# FASCICULE DE BREVET EUROPEEN

(11) **EP 3 916 765 B1**
(45) Date de publication et mention de la délivrance du brevet: **30.08.2023**
(21) Numéro de dépôt: 21176281.0
(22) Date de dépôt: 27.05.2021
(51) Int. Cl.: H01L 21/673

(54) **DISPOSITIF DE MAINTIEN DE PLAQUES, NOTAMMENT DES PLAQUES DE SILICIUM**
VORRICHTUNG ZUM HALTEN VON WAFERN, INSBESONDERE VON SILIZIUM-WAFERN
DEVICE FOR HOLDING WAFERS, ESPECIALLY SILICON WAFERS

(30) Priorité: 29.05.2020 FR 2005671
(43) Date de publication de la demande: 01.12.2021
(73) Titulaire: Commissariat à l'énergie atomique et aux énergies alternatives, 75015 Paris (FR)
(72) Inventeur: BOUTRY, Delphine, 38054 Grenoble Cedex 09 (FR); AUTILLO, Delphine, 38600 FONTAINE (FR); ENYEDI, Virginie, 38054 Grenoble Cedex 09 (FR); LARDIN, Thierry, 38054 Grenoble Cedex 09 (FR)
(74) Mandataire: INNOV-GROUP

(56) Documents cités:
- US-A- 5 169 453
- US-A1- 2006 027 171
- US-A1- 2015 187 622

## Description

### DOMAINE TECHNIQUE

Le domaine technique de l'invention est la manutention de substrats, notamment des substrats utilisés en microélectronique, en vue de leur transport ou de leur stockage.

### ART ANTERIEUR

Dans l'industrie microélectronique, on utilise des substrats, usuellement désignés par le terme « wafer ». Il s'agit de plaques circulaires, rigides et fines, sur lesquelles on effectue des étapes de microfabrication, de type dépôts de couches, gravures, et photolithographie. Le diamètre des plaques peut par exemple être égal à 200 mm et 300 mm. Chaque plaque peut comporter plusieurs centaines de puces électroniques. Chaque puce peut comporter un nombre très élevé de transistors, par exemple de l'ordre de 1.10⁹ transistors par puces. Généralement, les substrats sont en silicium.

Le passage d'une plaque de silicium vierge à une plaque finalisée nécessite plusieurs mois de production, au cours desquels on effectue des centaines d'étapes de fabrication de façon à former une multitude de puces sur la plaque. La plaque peut être transportée entre différents équipements. Elle peut également être temporairement stockée entre deux étapes de fabrication. Afin de ne pas compromettre les performances des puces, la maîtrise de la contamination constitue un enjeu particulièrement critique. En effet, une particule d'élément non souhaité ou une poussière de dimension submicronique se déposant sur une plaque peut rendre une puce inutilisable. Afin d'adresser la question de la contamination, c'est-à-dire la présence d'éléments (poussières, particules) indésirables, les opérations de microfabrication sur des substrats de silicium sont effectuées en salle blanche, dans des environnements propres et contrôlés.

Au cours de leur fabrication, les plaques de silicium peuvent devoir être transportées d'un équipement à un autre. A cette fin, on utilise des enceintes de confinement, permettant de transporter des plaques dans un environnement propre et étanche. Par exemple, dans la technologie 300 mm, on peut utiliser des containers en plastique usuellement désignés par le terme FOUP, acronyme de Front Opening Unified Pod (Caisson normalisé à ouverture frontale).

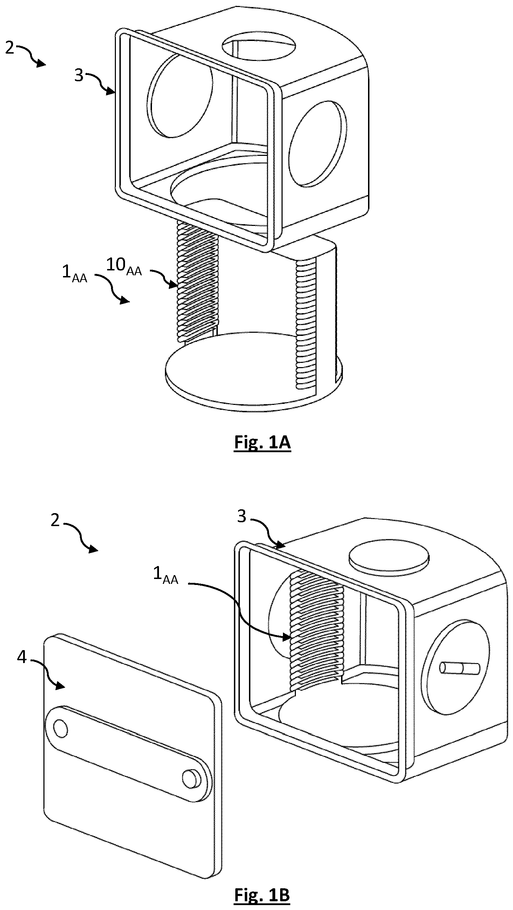

Un tel container est représenté sur les figures 1A et 1B. Il comporte une enceinte de confinement 2, formée d'une coque 3 destinée à être refermée par une porte 4. La coque 3 peut être équipée d'un dispositif de maintien 1_{AA} amovible, formé de supports 10_{AA} alignés horizontalement. Les supports sont destinés à supporter des plaques. L'indice AA désigne le fait qu'il s'agit d'une structure connue de l'art antérieur. Chaque support 10_{AA} est destiné à maintenir une plaque. Ainsi, les plaques sont maintenues les unes parallèles aux autres, en étant espacées les unes des autres. Dans l'exemple représenté sur les figures 1A et 1B, chaque support 10_{AA} se présente sous la forme d'un insert plan, horizontal, s'étendant de part et d'autre du dispositif de maintien 1_{AA}. Le dispositif de maintien 1_{AA} est amovible par rapport à la coque 3. Sur la figure 1A, on a représenté une introduction du dispositif de maintien dans une enceinte 2. Sur la figure 1B, on a représenté le dispositif de maintien à l'intérieur de l'enceinte 2. Une telle enceinte 2 présente une capacité de stockage de 25 plaques de diamètre 300 mm. Les supports peuvent être formées en PEEK (polyethercétone), tandis que la coque peut être formée en un matériau polymère de type polycarbonate ou COP (polycyclooléfine).

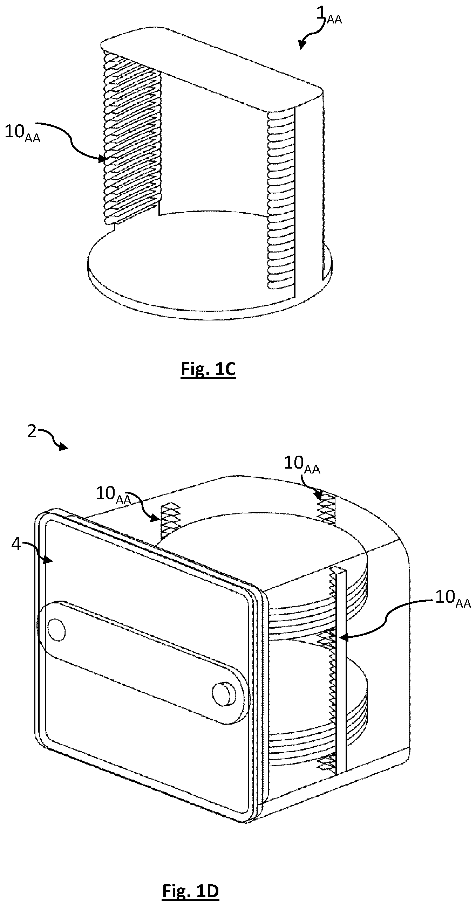

D'autres exemples de dispositifs adaptés au transport de substrats, connus de l'art antérieur, sont représentés sur les figures 1C et 1D. Sur la figure 1C, on a représenté un dispositif de maintien 1_{AA} usuellement désigné par le terme « panier » ou insert, destiné à être translaté dans une coque 3. Sur la figure 1D, on a représenté une enceinte comportant des supports étroits, une plaque étant maintenue par trois supports.

Dans la plupart des enceintes de confinement, chaque substrat est maintenu au niveau d'une zone adjacente de la périphérie circulaire du substrat, usuellement désignée bordure. Généralement, au niveau de la bordure, chaque substrat s'affine progressivement jusqu'à la périphérie circulaire. La périphérie circulaire est usuellement désignée par le terme anglosaxon bevel, signifiant chanfrein. Les enceintes de confinement peuvent constituer un point de transfert de contamination. En effet, des contaminants peuvent subsister au niveau des supports, et entraîner une contamination de substrats, en particulier au niveau de la bordure en face arrière, au cours des chargements -déchargements successifs. Les contaminants peuvent notamment être des espèces métalliques, par exemple Fe, Cr, Al, Ni, Cu, Ti, Ga, Co, Au, Ag, Pt.

Des dispositifs ont été proposés, de façon à limiter le transfert de contamination au niveau de supports de maintien de substrats. Ils sont par exemple décrits dans les documents US4471716, WO89/10629, ou GB2330944.

Les documents US2006/027171 A1, US2013/284683 A1, US5169453 et WO 01/09926 décrivent des dispositifs comportant des supports destinés à supporter des plaques de type wafer lors d'opérations de fabrication ou de traitements dans le domaine de la microélectronique, en particulier à haute température. La forme des supports permet de minimiser la surface de contact avec chaque plaque. Mais ces dispositifs ne sont pas adaptés au transport de plaques. Le document US2015/0187622 décrit un dispositif pour la manutention de plateaux supportant des puces microélectroniques prélevées à partir d'un wafer.

Un objectif de l'invention décrite ci-après est de proposer une solution permettant une réduction du risque de transfert de la contamination entre des supports, destinés à maintenir des plaques, et les plaques maintenues sur les supports, et cela en particulier lors du transport de plaques.

### EXPOSE DE L'INVENTION

Un premier objet de l'invention est un dispositif de maintien selon la revendication 1.

Ainsi, chaque support fait saillie à partir du montant auquel il est fixé.

Par hauteur d'appui, on entend une hauteur selon l'axe transversal.

Selon un mode de réalisation,
- le support s'étend parallèlement à l'axe transversal, selon une épaisseur ;
- l'épaisseur du support augmente entre l'extrémité proximale et la zone d'appui. L'épaisseur du support peut diminuer entre la zone d'appui et l'extrémité distale.

La distance d'extension peut être comprise entre 0,5 cm et 3 cm, et de préférence entre 1 cm et 2 cm.

Selon un mode de réalisation,
- l'extrémité de maintien s'étend à une hauteur, par rapport à la base du montant, supérieure à la hauteur d'appui du support associé à la cale de maintien.

La distance, perpendiculairement à l'axe transversal, entre le montant, auquel est reliée la cale de maintien, et l'extrémité de maintien, peut être inférieure à la distance d'extension.

Selon une possibilité, la cale de maintien comporte une première portion, s'étendant à partir du montant, vers l'espace interne, ainsi qu'une deuxième portion, s'étendant à partir de la première portion, vers le support, jusqu'à l'extrémité de maintien, de telle sorte que la plaque peut s'étendre entre le support et l'extrémité de maintien.

La cale de maintien peut être reliée au montant de façon amovible.

Quel que soit le mode de réalisation :
- la zone d'appui d'au moins un support peut former un méplat ou une arête ;
- la zone d'appui peut s'étendre jusqu'à l'extrémité distale ;
- le support peut s'étendre, le long du montant, parallèlement à un plan perpendiculaire, à l'axe transversal selon une largeur d'au moins 0.5 cm.

De préférence, le montant comporte une pluralité de supports, les supports fixés au montant étant disposés de façon à définir plusieurs hauteurs d'appui.

Selon un mode de réalisation, le dispositif comporte plusieurs montants, s'étendant parallèlement à l'axe transversal, en étant disposés autour de l'axe transversal, chaque montant comprenant au moins un support comportant les caractéristiques (i) à (iii) précédemment décrites, les supports étant disposés de telle sorte que lorsque l'axe transversal est orienté verticalement, des zones d'appui de plusieurs supports, respectivement fixés à différents montants, s'étendent dans un même plan horizontal. Selon ce mode de réalisation, les montants délimitent l'espace interne.

Selon un mode de réalisation, le montant s'étend autour de l'axe transversal, le montant décrivant, dans un plan perpendiculaire à l'axe transversal, une forme en U, le dispositif étant tel que lorsque l'axe transversal est orienté verticalement, la zone d'appui du support s'étend dans un plan horizontal. Selon ce mode de réalisation, le montant délimite l'espace interne.

Un deuxième objet de l'invention est une enceinte de confinement, destinée à recevoir et à confiner des plaques, l'enceinte étant délimitée par des parois transversales, l'enceinte comportant un dispositif de maintien selon le premier objet de l'invention, le dispositif étant disposé de telle sorte que le montant s'étend parallèlement à une paroi transversale de l'enceinte. Le dispositif de maintien peut être amovible, de façon à pouvoir être extrait ou introduit dans l'enceinte par exemple par translation. Le dispositif de maintien peut être intégré à l'enceinte, de telle sorte que le montant forme une paroi transversale de l'enceinte. Par paroi transversale, il est entendu une paroi parallèle à l'axe transversal.

L'invention sera mieux comprise à la lecture de l'exposé des exemples de réalisation présentés, dans la suite de la description, en lien avec les figures listées ci-dessous.

### FIGURES

Les figures 1A et 1B représentent une enceinte de confinement de l'art antérieur, permettant un transfert de plaques de silicium.
La figure 1C montre un exemple de panier, ou insert, de l'art antérieur, destiné à être inséré dans une enceinte de confinement, et destiné au transfert de plaques de silicium.
La figure 1D montre un autre exemple d'enceinte de confinement de l'art antérieur.
Les figures 2A à 2C schématisent une plaque de silicium.
La figure 3A représente un premier exemple de dispositif de maintien selon l'invention.
Les figures 3B à 3D illustrent d'autres configurations de dispositif de maintien selon l'invention.
La figure 4A représente des supports, fixés à deux montants d'un dispositif de maintien selon l'invention.
La figure 4B schématise une disposition de plaques à l'intérieur d'un dispositif de maintien tel que décrit en lien avec la figure 4A.
Les figures 5A à 5C montrent différentes configurations d'un support équipant un dispositif de maintien selon l'invention.
Les figures 6A et 6B illustrent un mode de réalisation, dans lequel chaque support est associé à une cale de maintien.
La figure 6C représente un autre mode de réalisation, dans lequel chaque support est associé à une cale de maintien.
Les figures 7A à 7C montrent un autre type de support selon l'invention.
La figure 8 schématise une disposition de plaques à l'intérieur d'un dispositif de maintien selon l'invention à l'aide d'un moyen de préhension.

### EXPOSE DE MODES DE REALISATION PARTICULIERS

Dans la suite du texte, le terme plaque désigne un substrat, en particulier un substrat à base de silicium. La plaque peut notamment être une plaque circulaire.

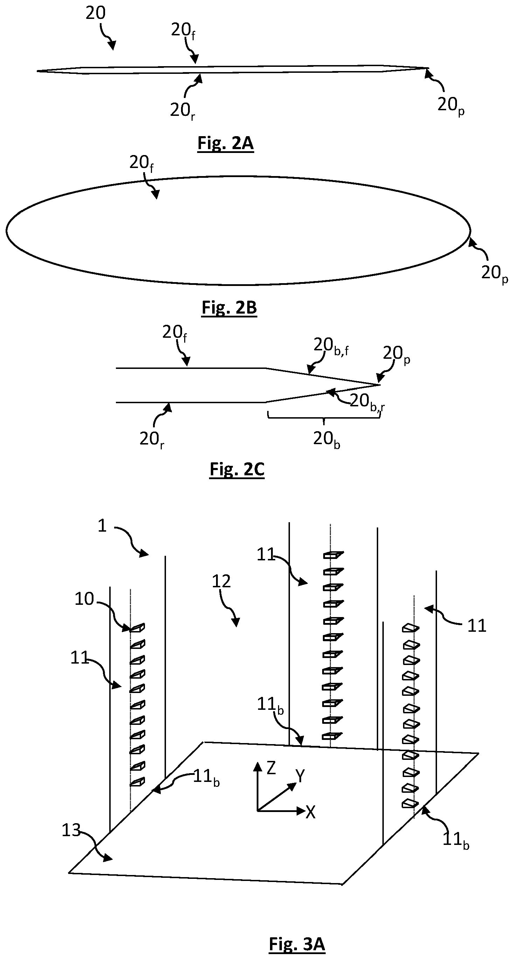

On a représenté, sur les figures 2A à 2C, une plaque 20, comportant une face avant 20_{f} et une face arrière 20ᵣ. La plaque 20 est délimitée par une périphérie (ou bevel) circulaire 20ₚ. Le diamètre de la plaque 20 peut être égal à 100 mm ou 150 mm ou 200 mm ou à 300 mm, voire davantage. D'une façon générale, le diamètre est de préférence compris entre 100 mm et 450 mm. La face avant 20_{f} s'étend parallèlement à la face arrière 20ᵣ. La plaque 20 comporte une bordure 20_{b}, adjacente de la périphérie 20ₚ. Au niveau de la bordure, la plaque s'amincit progressivement jusqu'à la périphérie 20ₚ. La bordure s'étend généralement selon une largeur inférieure à 1 cm à partir de la périphérie 20ₚ. La bordure 20_{b} comporte une partie 20_{b,f} côté face avant, et une partie 20_{b,r} côté face arrière.

Dans les dispositifs tels que décrits en lien avec les figures 1A à 1D, les supports 10_{AA} sont destinés à maintenir une plaque 20 en étant en contact avec la partie arrière 20_{b,r} de la bordure 20_{b}. Il en est de même des dispositifs décrits dans les références US4471716, WO89/10629, ou GB2330944 citées dans l'art antérieur.

Les inventeurs ont estimé qu'afin de limiter les transferts de contamination à partir des supports, il était important de réduire la surface de contact entre chaque support et chaque plaque 20.

La figure 3A représente un premier exemple de dispositif 1 de maintien de plaques selon l'invention. Le dispositif comporte trois montants 11, s'étendant parallèlement à un axe transversal Z. Chaque montant s'étend à partir d'une base 11_{b}. Les montants 11 délimitent un espace interne 12, destiné à être occupé par des plaques. Les bases 11_{b} de chaque montant 11 s'étendent, dans ce cas, à partir d'un fond 13 du dispositif. Dans l'exemple représenté, les montants 11 s'étendent perpendiculairement au fond 13, ce dernier s'étendant parallèlement à un plan radial P_{XY}. Le plan radial P_{XY} est perpendiculaire à l'axe transversal Z.

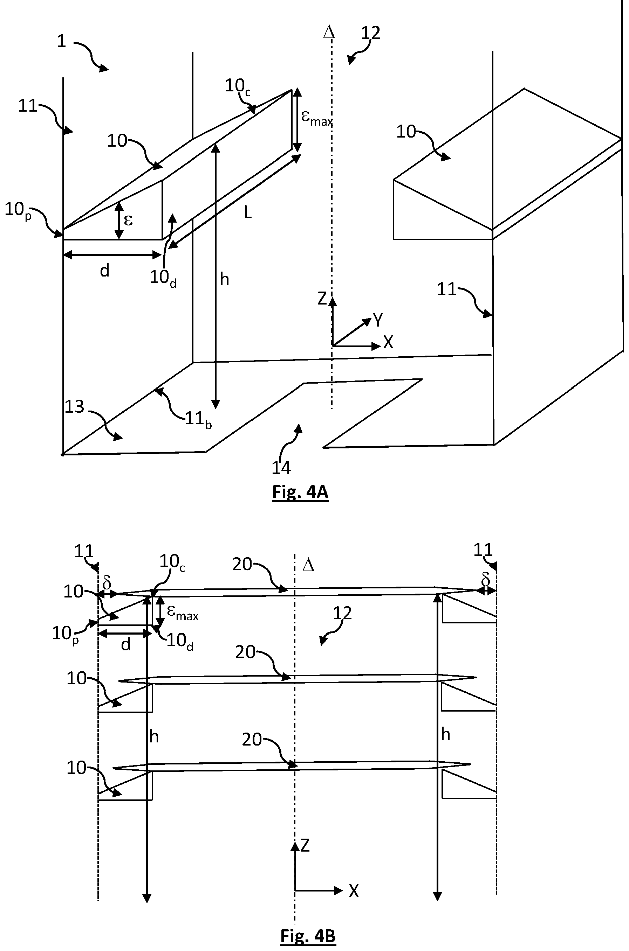

Les montants 11 comportent des supports 10, alignés sur chaque montant 11, parallèlement à l'axe transversal Z. Trois supports 10 respectivement disposés sur trois montants différents 11 définissent un plan d'appui parallèle au plan radial. Lorsque l'axe transversal Z est orienté verticalement, le plan d'appui est horizontal. Chaque support 10 définit une hauteur d'appui par rapport à sa base 11_{b}. Le dispositif est configuré de telle sorte que sur chaque montant 11, chaque support 10 définit une hauteur d'appui identique aux hauteurs d'appuis définies par deux supports respectivement fixés aux deux autres montants. Lorsque le plan radial P_{XY} est horizontal, le plan d'appui est également horizontal. L'espacement, selon l'axe transversal Z, entre deux supports adjacents 10 fixés à un même montant 11, est telle que deux plaques adjacentes ne se touchent pas. La distance entre deux supports adjacents est de préférence comprise entre 1 cm et 5 cm. La géométrie des supports 10, qui constitue un élément important de l'invention, est décrite plus loin en lien avec les figures 4A et 4B, ainsi que 5A à 5C.

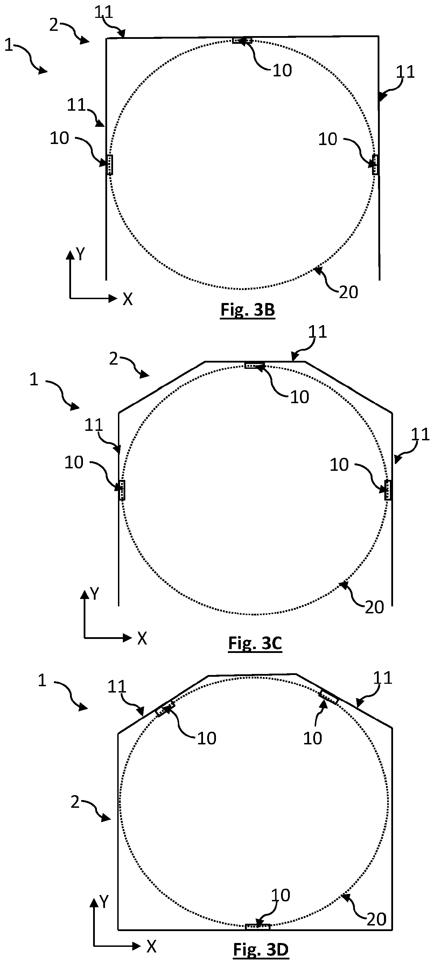

Le dispositif de maintien 1 schématisé sur la figure 3A est de type panier (ou insert) : il est destiné à être introduit dans une enceinte de confinement. Les figures 3B à 3D représentent des vues de dessus d'autres configurations possibles, dans lesquelles le dispositif de maintien 1 est intégré à une enceinte de confinement. Les montants 11 forment alors des parois transversales définissant un espace interne 12 dans l'enceinte de confinement 2. Les montants 11 s'étendent, à partir de leur base 11_{b}, parallèlement à l'axe transversal Z. Les supports 10 sont fixés aux montants 11, ces dernier formant des parois de l'enceinte. L'exemple de la figure 3B correspond à une enceinte de section parallélépipédique. Les exemples des figures 3C et 3D correspondent à une enceinte de section hexagonale, selon un hexagone non régulier. L'enceinte peut être fermée par une porte, comme décrit en lien avec l'art antérieur.

Sur les exemples représentés dans les figures 3A à 3D, le dispositif de maintien 1 comporte des supports 10 agencés le long de trois montants 11 différents. Les montants 11 sont agencés autour de l'axe transversal Z. Deux supports sont en vis-à-vis. Un support est orienté, dans le plan radial P_{XY}, différemment des deux autres supports. Dans l'exemple représenté sur la figure 4A, le dispositif de maintien 1 comporte deux montants 11 opposés l'un à l'autre, s'étendant parallèlement à l'axe transversal Z. De même que dans les exemples précédents, les montants 11 délimitent un espace interne 12, agencé pour être occupé par des plaques 20 maintenues sur les supports 10.

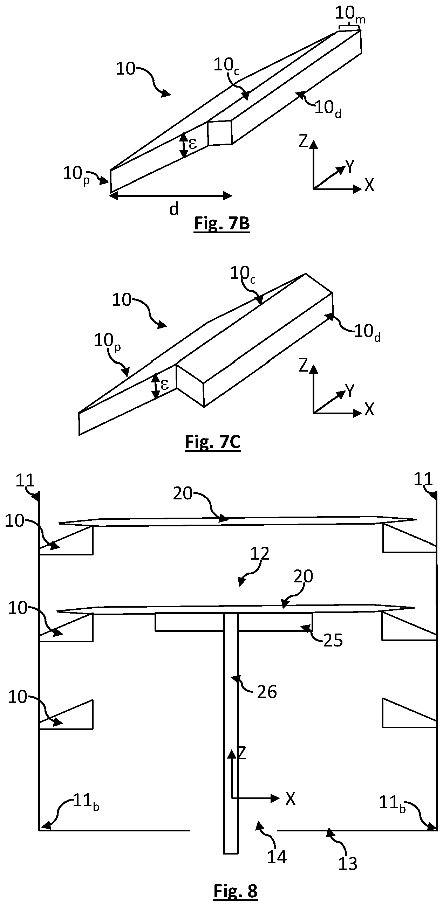

Quel que soit le mode de réalisation, le fond 13 n'est pas nécessairement plein, ni plat. Il peut notamment définir une ouverture 14, à travers laquelle il est possible d'introduire un moyen de préhension 25 d'une plaque 20, comme décrit ci-après, en lien avec la figure 8. Le fond 13 peut être entièrement ouvert, auquel cas il est délimité par les bases 11_{b} des montants transversaux 11.

Sur l'exemple de la figure 4A, on a représenté un premier exemple de supports 10, destinés à entrer en contact avec une plaque 20, et de préférence avec la bordure 20_{b,r} de la plaque, du côté de la face arrière 20ᵣ. Chaque support 10 est fixé à un montant 11, en étant disposé en saillie par rapport à ce dernier. Chaque support s'étend ainsi, vers l'espace interne 12, entre une extrémité proximale 10ₚ, reliée au montant 11, et une extrémité distale 10_{d}. Les termes distal et proximal sont définis par rapport au montant 11 sur lequel le support est fixé. Le dispositif de maintien 1 s'étend autour d'un axe central Δ, parallèle à l'axe transversal Z. Chaque support 10 s'étend à partir du montant 11 auquel il est fixé, en se rapprochant de l'axe central Δ. La distance entre l'extrémité proximale et l'extrémité distale, parallèlement au plan radial P_{XY}, est de préférence comprise entre 0,5 cm et 5 cm, et encore de préférence entre 0,5 cm et 3 cm. L'axe central peut être confondu avec l'axe transversal.

Chaque support 10 s'étend, parallèlement à l'axe transversal Z, selon une épaisseur ε. Dans l'exemple représenté, chaque support 10 présente une épaisseur ε variable entre l'extrémité proximale 10ₚ et l'extrémité distale 10_{d}. L'épaisseur ε augmente à partir de l'extrémité proximale 10ₚ, jusqu'à atteindre une épaisseur maximale εₘₐₓ. L'épaisseur maximale est par exemple comprise entre 0,5 cm et 2 cm. La partie du support dans laquelle l'épaisseur du support est maximale correspond à une zone d'appui 10_{c}, destinée à être en contact avec une plaque 20 déposée sur le support 10. L'épaisseur ε du support 10 augmente, de façon continue ou discontinue, jusqu'à la zone d'appui 10_{c}, au niveau de laquelle l'épaisseur du support 10 est maximale.

Dans l'exemple de la figure 4A, l'épaisseur ε du support 10 augmente, de façon continue et régulière, entre l'extrémité proximale 10ₚ et l'extrémité distale 10_{d}. La zone d'appui 10_{c} de chaque support prend la forme d'une arête ou d'un méplat. L'arête est alors ponctuelle ou sous forme d'une ligne rectiligne ou d'un arc de cercle. Chaque support 10 définit, au niveau de la zone d'appui 10_{c}, une hauteur d'appui h par rapport à la base 11_{b} du montant 11 auquel il est fixé. Cette dernière correspond à une distance, selon l'axe transversal Z, entre la zone d'appui 10_{c} et la base 11_{b} du montant 11. La distance d entre l'extrémité proximale 10ₚ et la zone d'appui 10_{c}, parallèlement au plan radial P_{XY}, est une distance d'extension d. La distance d'extension d est non nulle. Elle peut être comprise entre 5 mm et 2 cm ou 3 cm, de préférence entre 1 cm et 2 cm. De façon alternative, l'épaisseur du support peut augmenter de façon discontinue entre l'extrémité proximale 10ₚ et la zone d'appui 10_{c}.

Le fait que la zone d'appui 10_{c} soit en forme d'arête minimise la surface de contact entre le support et la plaque 20. Cela diminue le risque de transfert de contamination entre le support et la plaque ou réciproquement.

La figure 4B représente une vue en coupe, selon un plan transversal P_{XZ}, dans laquelle on a schématisé plusieurs plaques 20 en appui sur les zones d'appui 10_{c} de supports 10. On comprend que de tels supports 10 minimisent la surface de contact de chaque plaque avec un support, cette dernière correspondant à la zone d'appui 10_{c}. Le dispositif 1 comporte, au niveau de chaque montant 11, des supports 10, de telle sorte les hauteurs d'appui respectivement définies par les supports 10 d'un montant 11 sont similaires aux hauteurs d'appui respectivement définies par les supports fixés à l'autre montant.

Chaque support s'étend, le long du montant 11 auquel il est fixé, selon une largeur L, dans le plan radial P_{XY}. Sur la figure 4A, la largeur est définie selon l'axe Y. Cette dernière peut être comprise entre quelques mm, par exemple 5 mm, et plusieurs cm, voire dizaines de cm. Lorsque la largeur L est faible, par exemple inférieure à 3 cm, il est préférable de disposer d'au moins 3 supports, respectivement espacés les uns des autres, de façon à pouvoir permettre un maintien stable des plaques. Lorsque la largeur L de chaque support 10 est suffisante, il est possible de disposer deux supports, opposés l'un à l'autre, comme représenté sur la figure 4B. Selon une variante, le dispositif comporte un montant décrivant, dans le plan radial P_{XY}, une forme de U, ou une partie d'un U, autour de l'axe transversal Z. Lorsque le montant décrit une forme en U, le dispositif peut ne comporter qu'un seul montant.

Les dimensions du dispositif sont telles que lorsque les plaques 20 s'appuient sur des supports, 10 à une même hauteur d'appui, la périphérie 20ₚ de chaque plaque 20 n'est pas en contact avec un montant 11 du dispositif. De préférence, la distance δ, entre la périphérie 20ₚ d'une plaque 20 et le montant 11 est supérieure à 5 mm. Elle peut par exemple être égale à 1 cm. Cela permet de maintenir les plaques espacées des montants 11, ce qui évite le risque de transfert de contamination depuis et vers les montants 11.

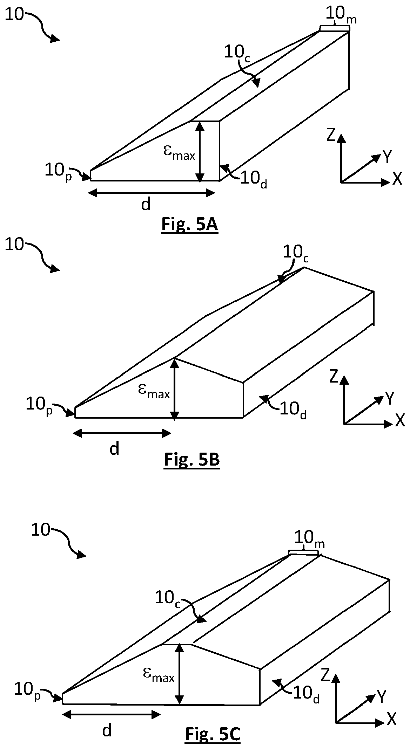

Sur la figure 5A, on a représenté une variante d'un support 10 tel que décrit en lien avec les figures 4A et 4B. Selon cette variante, la zone d'appui comporte un méplat 10ₘ, au niveau duquel l'épaisseur ε du support 10, en l'occurrence l'épaisseur maximale εₘₐₓ, est constante. Un tel méplat permet un maintien plus stable des plaques. La longueur du méplat, entre l'extrémité proximale à l'extrémité distale, est de préférence inférieure à 1 cm, voire à 0,5 cm.

Dans les exemples représentés sur les figures 4A, 4B et 5A, la zone d'appui 10_{c} inclut l'extrémité distale 10_{d} du support 10. Sur les figures 5B et 5C, on a représenté des autres variantes, dans lesquelles la zone d'appui 10_{c} s'étend entre l'extrémité proximale 10ₚ et l'extrémité distale 10_{d}.

Quel que soit le mode de réalisation, chaque support 10 est obtenu à partir d'un matériau solide, par exemple par moulage. Le matériau composant chaque support 10 peut être un polymère, par exemple du polycarbonate, ou du PEEK, du Polytétrafluoroéthylène (PTFE) ou, d'une façon générale, un polymère ou un plastique considéré comme ne comportant pas d'élément métallique. Avantageusement, chaque support, et éventuellement les montants, sont en téflon. Le téflon est un matériau résistant à des agent de lavage agressifs, et présente l'intérêt d'être léger. Cependant, la température de fusion du téflon est de l'ordre de 330 °C, ce qui rend ce matériau non compatible dans des dispositifs mettant en oeuvre des procédés à haute température.

Chaque support 10 peut être fixé de façon amovible sur le montant 11 à partir duquel il s'étend. Cela permet de détacher le support 10, par exemple pour le nettoyer ou le remplacer.

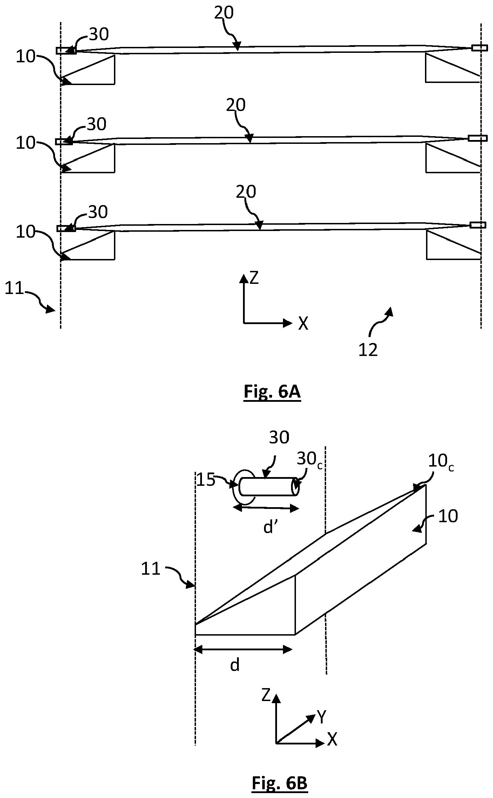

Les figures 6A et 6B représentent un mode de réalisation dans lequel un support 10 est associé à une cale de maintien 30. La fonction de la cale de maintien est d'exercer une pression sur une plaque 20 s'appuyant sur le support 10. La pression exercée par la cale de maintien 30 permet de bloquer un mouvement de la plaque 20 parallèlement au plan radial P_{XY} et/ou selon l'axe Z.

La cale de maintien 30 peut être fixée ou insérée dans le même montant 11 que le support 10. La fixation de la cale de maintien 30 sur le montant 11 est de préférence réversible. A cet effet, une ouverture 15 est pratiquée dans le montant 11. La cale de maintien 30 est alors insérée dans l'ouverture 15. Les dimensions de l'ouverture 15 et de la cale 30 sont complémentaires de manière à ce qu'une fois insérée dans l'ouverture, la cale ne peut pas tomber durant le transport. Il est alors nécessaire d'exercer une légère action mécanique pour désolidariser la cale 30 de l'ouverture 15 par exemple pour opérer un nettoyage ou un remplacement. Dans l'exemple représenté sur la figure 6B, la cale de maintien 30 présente une géométrie cylindrique de révolution.

La cale de maintien 30 s'étend, à partir du montant 11, vers l'espace interne 12, jusqu'à une extrémité de maintien 30_{c}, cette dernière étant destinée à s'appuyer radialement contre une plaque 20 supportée par un support 10. La cale de maintien 30 s'étend vers l'extrémité de maintien 30_{c} en se rapprochant de l'axe central Δ, et de préférence perpendiculairement à ce dernier. Dans l'exemple représenté sur la figure 6A, la cale de maintien 30 est agencée de telle sorte que lorsqu'une plaque 20 est disposée sur un support 10, la périphérie 20ₚ s'appuie contre la cale de maintien 30, comme représenté sur la figure 6A. La cale de maintien 30 s'étend, à partir du montant 11, selon une distance de maintien d'. Dans cet exemple :
- la distance de maintien d'est inférieure à la distance d'extension d, de telle sorte que la cale de maintien 30 soit en contact avec la périphérie 20ₚ de la plaque lorsque la face arrière 20ᵣ ou la bordure 20_{b,r} de la plaque 20 est disposée sur la zone d'appui 10ₘ du support.
- l'extrémité de maintien 30_{c} est disposée à une hauteur, par rapport à la base 11_{b}, supérieure à la hauteur d'appui h définie par le support 10 auquel la cale de maintien est associée : la différence de hauteur correspond ici sensiblement à la demi-épaisseur de la plaque. Par sensiblement, on entend à une marge d'erreur près, la marge d'erreur pouvant par exemple être ±30% ou ±20%.

La cale de maintien 30 permet alors un blocage d'un mouvement de la plaque dans le plan radial P_{XY}. Le contact de la cale de maintien 30 contre la plaque permet également un blocage d'un mouvement de la plaque 20 selon l'axe transversal Z, en dessus du support. Ainsi, une cale peut permettre un maintien de la plaque selon toutes les directions.

La cale de maintien 30 est formée d'un matériau solide. Il peut s'agir du même matériau que celui formant le support. Il peut également s'agir de téflon (polytetrafluoréthylène), ou d'un autre matériau compatible avec des procédés de nettoyage à l'aide d'une solution d'acide, par exemple l'acide fluorhydrique ou l'acide nitrique. Le recours à des cales de maintien 30 amovibles facilite leur nettoyage. La cale de maintien 30 peut être formée d'un matériau souple, de type caoutchouc ou élastomère, apte à se déformer au contact d'une plaque 20. La cale de maintien 30 peut alors être jetable. Selon une possibilité, la cale de maintien et le support sont en téflon.

De préférence, plusieurs supports 10, respectivement fixés à des montants différents, et définissant une même hauteur d'appui sont chacun associées à une cale de maintien 30. Ainsi, une même plaque 20, reposant sur les supports 10, est maintenue par plusieurs cales de maintien. Le recours à des cales de maintien est particulièrement adapté lorsque l'enceinte de confinement 2, à l'intérieur de laquelle est disposé le dispositif de maintien 1 comportant les plaques, est destinée à être transportée. Cela permet de réduire des vibrations des plaques durant le transport.

Selon une variante, l'extrémité de maintien 30_{c} est disposée, par rapport à la zone d'appui 10_{c}, à une hauteur correspondant sensiblement à l'épaisseur de la plaque. Dans ce cas, la cale de maintien s'appuie contre la face avant 20_{f} de la plaque ou contre la bordure 20_{b,f} du côté de la face avant.

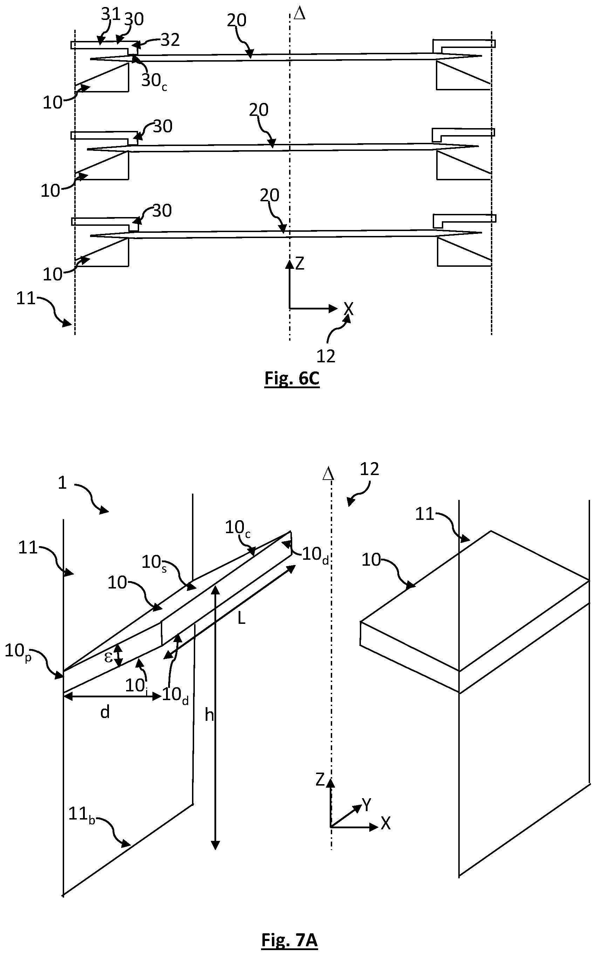

La figure 6C représente une autre configuration de cale de maintien 30, dans laquelle la cale de maintien comporte :
- une première portion 31 s'étendant, à partir du montant 11, vers l'espace interne 12, c'est-à-dire en se rapprochant de l'axe central Δ, et de préférence perpendiculairement à ce dernier.
- une deuxième portion 32 s'étendant, à partir de la première portion 31, vers le support 10, jusqu'à l'extrémité de maintien 30_{c}.

Selon cette configuration, la cale de maintien 30 est agencée pour s'appuyer transversalement (i-e selon l'axe Z) contre une plaque 20 disposée sur le support 10, en cas de mouvement de la plaque selon l'axe transversal Z. La cale de maintien permet alors un blocage du mouvement de la plaque selon l'axe transversal Z, afin d'éviter une chute de la plaque 20 du support 10, ou un déplacement de la plaque sur un support adjacent. Le contact de la cale de maintien 30 contre la plaque 20 permet également un blocage d'un mouvement de la plaque, par rapport au support 10, selon le plan radial P_{XY} ou selon l'axe transversal Z

Les différents types de cales de maintien 30 respectivement décrits en lien avec les figures 6A à 6C peuvent être combinés.

Comme représenté sur les figures 6A et 6C, chaque cale de maintien 30 s'étend à partir du montant, auquel elle est reliée, entre deux supports successifs, définissant respectivement deux hauteurs d'appui successives. Ainsi, l'extrémité de maintien 30_{c} de chaque cale 30 s'étend à une hauteur, par rapport à la base, comprise entre deux hauteurs d'appui successives respectivement définies par les deux supports successifs. Chaque cale de maintien est directement reliée à un montant, ce dernier étant parallèle à l'axe transversal, sans pièce intermédiaire entre la cale de maintien et le montant. Une cale de maintien n'est pas configurée pour exercer la fonction d'un support, c'est-à-dire pour supporter le poids d'une plaque. La cale de maintien est destinée à maintenir la plaque en appui sur un support, en évitant un mouvement de la plaque par rapport au support.

Les figures 7A à 7C représentent un autre exemple de support 10. Le support présente des caractéristiques similaires à celles précédemment décrites en lien avec les figures 4A, 4B, 5A, 5B, 5C, 6A et 6B, à l'exception de son épaisseur ε, qui est constante. Le support 10 s'étend, selon une distance d'extension d, entre une extrémité proximale 10ₚ et une extrémité distale 10_{d}. La distance d'extension d est non nulle. Le support 10 définit une zone d'appui 10_{c}, entre l'extrémité proximale et l'extrémité distale. La hauteur d'appui h, à laquelle s'étend la zone d'appui 10_{c}, par rapport à la base 11_{b}, est supérieure à la hauteur entre l'extrémité proximale 10ₚ et la base 11_{b}. Entre l'extrémité proximale 10ₚ et l'extrémité distale 10_{d}, le support 10 s'étend entre une face inférieure 10ᵢ et une face supérieure 10ₛ parallèles l'une à l'autre.

Sur la figure 7B, on a représenté un support d'épaisseur constante, du même type que le support représenté sur la figure 7A, et comportant un méplat 10ₘ au niveau de la zone d'appui 10_{c}. Sur la figure 7C, on a représenté un autre support de même type, dont la zone d'appui 10_{c} est située entre l'extrémité proximale 10ₚ et l'extrémité distale 10_{d}.

Les supports décrits en lien avec les figures 7A à 7C peuvent être associés à des cales de maintien 30 telles que décrites en lien avec les figures 6A à 6C.

Comme précédemment évoqué, le dispositif de maintien 1 est soit intégré dans une enceinte de confinement 2, les montants 11 formant alors une partie des parois de l'enceinte, soit destiné à être inséré dans une enceinte de confinement, les montants 11 s'étendant alors parallèlement à des parois de l'enceinte 2. De préférence, lors de l'utilisation du dispositif de maintien 1, le plan radial P_{XY} est horizontal.

Une application visée du dispositif de maintien 1 est le rangement de plaques de silicium 20 destinées à des applications dans le domaine de la microélectronique. L'utilisation comporte alors une insertion de plaques de silicium 20 dans le dispositif de maintien 1, de telle sorte que la bordure arrière 20_{b,r} ou la face arrière 20ᵣ de chaque plaque repose sur la zone d'appui 10_{c} de différents supports 10, de préférence horizontalement. Lorsque des supports sont associés à une cale de maintien 30, chaque plaque, reposant sur un support, est bloquée par des cales de maintien. Lorsque les cales de maintien 30 sont amovibles, elles sont insérées dans le dispositif avant l'insertion des plaques dans le dispositif de maintien si l'on utilise les cales de maintien 30 telles que représentées sur la figure 6B, ou après l'insertion des plaques dans le dispositif de maintien si l'on utilise les cales de maintien 30 telles que représentées sur la figure 6C.

Lors de l'insertion des plaques dans le dispositif, chaque plaque 20 peut être manipulée par une pince ou par un moyen de préhension de type « vacuum wand » ou « vacuum pipette » (pipette à vide), appliquée contre la face arrière 20ᵣ de chaque plaque. Les plaques peuvent être insérées une à une, le moyen de préhension étant translaté à travers une ouverture 14 ménagée dans le fond 13. La géométrie du dispositif 1, en particulier l'ouverture 14, est alors adaptée à une translation du moyen de préhension entre les montants 11. On dispose alors les plaques par hauteur d'appui décroissante. La première plaque disposée dans le dispositif au niveau des supports présentant la plus grande hauteur d'appui, puis on dispose successivement l'ensemble des plaques sur des supports présentant successivement une hauteur d'appui de plus en plus faible. Les bases 11_{b} de chaque montant 11 s'étendant à partir du fond 13 du dispositif 1, la hauteur d'appui h peut être mesurée par rapport au fond 13.

Le moyen de préhension peut être fixé, de manière amovible, au dispositif de maintien 1, en étant centré par rapport à ce dernier, de façon à faciliter un centrage des plaques 20 par rapport aux montants 11 délimitant l'espace interne 12. Comme représenté sur la figure 8, le moyen de préhension peut comporter une platine 25, dotée d'une buse d'aspiration 26. La buse d'aspiration permet de plaquer la plaque 20 contre la platine 25 selon le principe d'une pompe à vide. La platine 25 peut être mobile en translation, parallèlement à l'axe transversal Z, à travers le panier, en étant centrée par rapport aux montants 11. Sur la figure 8, les supports sont tels que décrits en lien avec les figures 4A à 4B.

Le dispositif est essentiellement destiné à au stockage et au transport de plaques. Il n'est pas destiné à être intégré dans un équipement dédié à la mise en oeuvre d'une étape de fabrication microélectronique ou de traitement d'une plaque.

## Revendications

1. Dispositif de maintien (1), destiné à recevoir au moins une plaque (20), en vue du stockage ou du transport de ladite plaque, le dispositif définissant un espace interne (12), destiné à être occupé par les plaques, le dispositif comportant :
- au moins un montant, s'étendant parallèlement à un axe transversal (Z), à partir d'une base (11_{b}), le montant délimitant l'espace interne (12);
- plusieurs supports (10), chaque support étant fixé sur le montant (11), chaque support s'étendant, à partir du montant (11), vers l'espace interne (12), entre une extrémité proximale (10ₚ), reliée au montant, et une extrémité distale (10_{d});
le dispositif étant tel que :
- (i) chaque support comporte une zone d'appui (10_{c}), située entre l'extrémité proximale et l'extrémité distale, ou à l'extrémité distale;
- (ii) la zone d'appui (10_{c}) est située à une distance d'extension (d) par rapport à l'extrémité proximale (10ₚ), la distance d'extension étant considérée perpendiculairement à l'axe transversal;
- (iii) la zone d'appui de chaque support définit une hauteur d'appui (h), par rapport à la base (11_{b}), la hauteur d'appui étant supérieure à une hauteur entre l'extrémité proximale et la base, les supports fixés au montant étant disposés de façon à définir plusieurs hauteurs d'appui (h).
de telle sorte que chaque support est configuré pour supporter la plaque, la plaque reposant sur la zone d'appui du support ;
le dispositif étant **caractérisé en ce qu'**il comporte une cale de maintien (30), telle que
- la cale de maintien est reliée au même montant qu'au moins deux supports successifs ;
- la cale de maintien s'étend, entre les deux supports successifs, à partir du montant auquel elle est reliée, vers l'espace interne (12), jusqu'à une extrémité de maintien (30_{c});
de telle sorte que l'extrémité de maintien s'appuie contre la plaque lorsque cette dernière est disposée sur un support.

2. Dispositif selon l'une quelconque des revendications précédentes, dans lequel la cale de maintien est reliée au montant de façon amovible.

3. Dispositif selon la revendication 2, dans lequel le montant, auquel est relié la cale de maintien, comporte une ouverture (15), dans laquelle la cale de maintien peut être insérée.

4. Dispositif selon l'une quelconque des revendications précédentes, dans lequel :
- le support s'étend parallèlement à l'axe transversal (Z), selon une épaisseur (ε) ;
- l'épaisseur du support augmente entre l'extrémité proximale (10ₚ) et la zone d'appui (10_{c}).

5. Dispositif selon la revendication 4, dans lequel l'épaisseur (ε) du support diminue entre la zone d'appui (10_{c}) et l'extrémité distale (10_{d}).

6. Dispositif selon l'une quelconque des revendications précédentes, dans lequel la distance d'extension (d) est comprise entre 0,5 cm et 3 cm, et de préférence entre 1 cm et 2 cm.

7. Dispositif selon l'une quelconque des revendications précédentes, dans lequel la distance, perpendiculairement à l'axe transversal, entre le montant (11), auquel est reliée la cale de maintien (30), et l'extrémité de maintien (30_{c}), est inférieure à la distance d'extension (d).

8. Dispositif selon l'une quelconque des revendications précédentes, dans lequel la cale de maintien comporte une première portion (31), s'étendant à partir du montant, vers l'espace interne (12), ainsi qu'une deuxième portion (32), s'étendant à partir de la première portion, vers le support (10), jusqu'à l'extrémité de maintien (30_{c}), de telle sorte que la plaque peut s'étendre entre le support (10) et l'extrémité de maintien (30_{c}) .

9. Dispositif selon l'une quelconque des revendications précédentes, dans laquelle la zone d'appui (10_{c}) d'au moins un support forme un méplat (10ₘ) ou une arête.

10. Dispositif selon l'une quelconque des revendications précédentes, dans lequel la zone d'appui (10_{c}) s'étend jusqu'à l'extrémité distale (10_{d}).

11. Dispositif selon l'une quelconque des revendications précédentes, dans lequel chaque support s'étend, le long du montant (11), parallèlement à un plan perpendiculaire à l'axe transversal (Z), selon une largeur (L) d'au moins 0.5 cm.

12. Dispositif selon l'une quelconque des revendications précédentes, comportant plusieurs montants (11), s'étendant parallèlement à l'axe transversal (Z), en étant disposés autour de l'axe transversal (Z), chaque montant comprenant au moins un support (10) comportant les caractéristiques (i) à (iii) de la revendication 1, les supports étant disposés de telle sorte que lorsque l'axe transversal (Z) est orienté verticalement, des zones d'appui (10_{c}) de plusieurs supports, respectivement fixés à différents montants, s'étendent dans un même plan horizontal.

13. Dispositif selon l'une quelconque des revendications précédentes, dans lequel la cale de maintien et le support sont en téflon.

14. Enceinte de confinement (2), destinée à recevoir et à confiner des plaques (20), l'enceinte étant délimitée par des parois transversales, l'enceinte comportant un dispositif de maintien (1) selon l'une quelconque des revendications précédentes, le dispositif étant disposé de telle sorte que le montant (11) s'étend parallèlement à une paroi transversale de l'enceinte.

15. Enceinte de confinement selon la revendication 14, dans lequel le dispositif de maintien (1) est:
- amovible, de façon à pouvoir être extrait ou introduit dans l'enceinte (2) par translation;
- ou intégré à l'enceinte, de telle sorte que le montant forme une paroi transversale de l'enceinte (2).

## Patentansprüche

1. Haltevorrichtung (1), welche dazu bestimmt ist, mindestens einen Wafer (20) zur Lagerung oder zum Transport des Wafers aufzunehmen, wobei die Vorrichtung einen inneren Raum (12) definiert, der dazu bestimmt ist, von den Wafern eingenommen zu werden, wobei die Vorrichtung aufweist:
- mindestens eine Stütze, die sich von einem Fuß (11_{b}) aus parallel zu einer Querachse (Z) erstreckt, wobei die Stütze den inneren Raum (12) begrenzt;
- mehrere Träger (10), wobei jeder Träger an der Stütze (11) befestigt ist, wobei sich jeder Träger von der Stütze (11) aus zwischen einem proximalen Ende (10ₚ), das mit der Stütze verbunden ist, und einem distalen Ende (10_{d}) in Richtung des inneren Raumes (12) erstreckt;
wobei die Vorrichtung so beschaffen ist, dass:
- (i) jeder Träger einen Auflagebereich (10_{c}) aufweist, der sich zwischen dem proximalen Ende und dem distalen Ende oder am distalen Ende befindet;
- (ii) der Auflagebereich (10_{c}) sich in einem Erstreckungsabstand (d) in Bezug auf das proximale Ende (10ₚ) befindet, wobei der Erstreckungsabstand senkrecht zur Querachse betrachtet wird;
- (iii) der Auflagebereich jedes Trägers eine Auflagehöhe (h) in Bezug auf den Fuß (11_{b}) definiert, wobei die Auflagehöhe größer als eine Höhe zwischen dem proximalen Ende und dem Fuß ist, wobei die an der Stütze befestigten Träger so angeordnet sind, dass sie mehrere Auflagehöhen (h) definieren,
derart, dass jeder Träger dafür ausgelegt ist, den Wafer abzustützen, wobei der Wafer auf dem Auflagebereich des Trägers ruht;
wobei die Vorrichtung **dadurch gekennzeichnet ist, dass** sie einen Halteklotz (30) aufweist, derart, dass
- der Halteklotz mit derselben Stütze wie mindestens zwei aufeinander folgende Träger verbunden ist;
- der Halteklotz sich zwischen den zwei aufeinander folgenden Trägern von der Stütze aus, mit welcher er verbunden ist, in Richtung des inneren Raumes (12) bis zu einem Halteende (30_{c}) erstreckt;
derart, dass das Halteende an dem Wafer anliegt, wenn dieser Letztere auf einem Träger angeordnet ist.

2. Vorrichtung nach einem der vorhergehenden Ansprüche, wobei der Halteklotz lösbar mit der Stütze verbunden ist.

3. Vorrichtung nach Anspruch 2, wobei die Stütze, mit welcher der Halteklotz verbunden ist, eine Öffnung (15) aufweist, in welche der Halteklotz eingesetzt werden kann.

4. Vorrichtung nach einem der vorhergehenden Ansprüche, wobei:
- der Träger sich parallel zur Querachse (Z) entlang einer Dicke (ε) erstreckt;
- die Dicke des Trägers zwischen dem proximalen Ende (10ₚ) und dem Auflagebereich (10_{c}) zunimmt.

5. Vorrichtung nach Anspruch 4, wobei sich die Dicke (ε) des Trägers zwischen dem Auflagebereich (10_{c}) und dem distalen Ende (10_{d}) verringert.

6. Vorrichtung nach einem der vorhergehenden Ansprüche, wobei der Erstreckungsabstand (d) zwischen 0,5 cm und 3 cm und vorzugsweise zwischen 1 cm und 2 cm beträgt.

7. Vorrichtung nach einem der vorhergehenden Ansprüche, wobei der Abstand, senkrecht zur Querachse, zwischen der Stütze (11), mit welcher der Halteklotz (30) verbunden ist, und dem Halteende (30_{c}) kleiner als der Erstreckungsabstand (d) ist.

8. Vorrichtung nach einem der vorhergehenden Ansprüche, wobei der Halteklotz einen ersten Abschnitt (31), der sich von der Stütze aus in Richtung des inneren Raumes (12) erstreckt, sowie einen zweiten Abschnitt (32), der sich vom ersten Abschnitt aus in Richtung des Trägers (10) bis zum Halteende (30_{c}) erstreckt, aufweist, derart, dass sich der Wafer zwischen dem Träger (10) und dem Halteende (30_{c}) erstrecken kann.

9. Vorrichtung nach einem der vorhergehenden Ansprüche, wobei der Auflagebereich (10_{c}) mindestens eines Trägers eine Abflachung (10ₘ) oder eine Kante bildet.

10. Vorrichtung nach einem der vorhergehenden Ansprüche, wobei sich der Auflagebereich (10_{c}) bis zum distalen Ende (10_{d}) erstreckt.

11. Vorrichtung nach einem der vorhergehenden Ansprüche, wobei sich jeder Träger entlang der Stütze (11) parallel zu einer zur Querachse (Z) senkrechten Ebene über ein Breite (L) von mindestens 0,5 cm erstreckt.

12. Vorrichtung nach einem der vorhergehenden Ansprüche, welche mehrere Stützen (11) aufweist, die sich parallel zur Querachse (Z) erstrecken, wobei sie um die Querachse (Z) herum angeordnet sind, wobei jede Stütze mindestens einen Träger (10) umfasst, der die Merkmale (i) bis (iii) von Anspruch 1 aufweist, wobei die Träger derart angeordnet sind, dass, wenn die Querachse (Z) vertikal ausgerichtet ist, Auflagebereiche (10_{c}) mehrerer jeweils an unterschiedlichen Stützen befestigter Träger sich in derselben horizontalen Ebene erstrecken.

13. Vorrichtung nach einem der vorhergehenden Ansprüche, wobei der Halteklotz und der Träger aus Teflon bestehen.

14. Schutzbehälter (2), welcher dazu bestimmt ist, Wafer (20) aufzunehmen und einzuschließen, wobei der Behälter von Querwänden begrenzt wird, wobei der Behälter eine Haltevorrichtung (1) nach einem der vorhergehenden Ansprüche aufweist, wobei die Vorrichtung derart angeordnet ist, dass sich die Stütze (11) parallel zu einer Querwand des Behälters erstreckt.

15. Schutzbehälter nach Anspruch 14, wobei die Haltevorrichtung (1):
- lösbar ist, so dass sie durch Translation aus dem Behälter (2) gezogen oder in ihn eingeführt werden kann;
- oder in den Behälter integriert ist, so dass die Stütze eine Querwand des Behälters bildet.

## Claims

1. Holding device (1) intended to accept at least one wafer (20) for the purposes of storing or transporting said wafer, the device defining an internal space (12) intended to be occupied by the wafers, the device comprising:
- at least one upright, extending parallel to a transverse axis (Z) from a base (11_{b}), the upright delimiting the internal space (12);
- several supports (10), each support being fixed to the upright (11), each support extending, from the upright (11), towards the internal space (12), between a proximal end (10ₚ), connected to the upright, and a distal end (10_{d});
the device being such that:
- (i) each support comprises a bearing zone (10_{c}), situated between the proximal end and the distal end, or at the distal end;
- (ii) the bearing zone (10_{c}) is situated at an extension distance (d) from the proximal end (10ₚ), the extension distance being considered perpendicular to the transverse axis;
- (iii) the bearing zone of each support defines a bearing height (h) relative to the base (11_{b}), the bearing height being greater than a height between the proximal end and the base, the supports fixed to the upright being positioned in such a way as to define several bearing heights (h),
such that each support is configured to support the wafer, the wafer resting on the bearing zone of the support;
the device being **characterized in that** it comprises a holding block (30), such that
- the holding block is connected to the same upright as at least two successive supports;
- the holding block extends, between the two successive supports, from the upright to which it is connected toward the internal space (12) as far as a holding end (30_{c});
such that the holding end bears against the wafer when the latter is placed on a support.

2. Device according to any one of the preceding claims, wherein the holding block is connected removably to the upright.

3. Device according to Claim 2, wherein the upright to which the holding block is connected has an opening (15) into which the holding block can be inserted.

4. Device according to any one of the preceding claims, wherein:
- the support extends parallel to the transverse axis (Z) with a thickness (ε);
- the thickness of the support increases between the proximal end (10ₚ) and the bearing zone (10_{c}).

5. Device according to Claim 4, wherein the thickness (ε) of the support decreases between the bearing zone (10_{c}) and the distal end (10_{d}).

6. Device according to any one of the preceding claims, wherein the extension distance (d) is comprised between 0.5 cm and 3 cm and preferably between 1 cm and 2 cm.

7. Device according to any one of the preceding claims, wherein the distance, perpendicular to the transverse axis, between the upright (11), to which the holding block (30) is connected, and the holding end (30_{c}) is less than the extension distance (d).

8. Device according to any one of the preceding claims, wherein the holding block comprises a first portion (31), extending from the upright towards the internal space (12), and a second portion (32), extending from the first portion toward the support (10) as far as the holding end (30_{c}), such that the wafer can extend between the support (10) and the holding end (30_{c}).

9. Device according to any one of the preceding claims, wherein the bearing zone (10_{c}) of at least one support forms a flat (10ₘ) or a ridge.

10. Device according to any one of the preceding claims, wherein the bearing zone (10_{c}) extends as far as the distal end (10_{d}).

11. Device according to any one of the preceding claims, wherein each support extends, along the upright (11), parallel to a plane perpendicular to the transverse axis (Z) along a width (L) of at least 0.5 cm.

12. Device according to any one of the preceding claims, comprising several uprights (11) extending parallel to the transverse axis (Z) and positioned around the transverse axis (Z), each upright comprising at least one support (10) comprising features (i) to (iii) of claim 1, the supports being positioned in such a way that, when the transverse axis (Z) is oriented vertically, the bearing zones (10_{c}) of several supports, which are respectively fixed to different uprights, extend in one and the same horizontal plane.

13. Device according to any one of the preceding claims, wherein the holding block and the support are made of Teflon.

14. Container (2) intended to accept and contain wafers (20), the container being delimited by transverse walls, the container comprising a holding device (1) according to any one of the preceding claims, the device being positioned in such a way that the upright (11) extends parallel to a transverse wall of the container.

15. Container according to Claim 14, wherein the holding device (1) is:
- removable, so that it can be extracted from or introduced into the container (2) by a translational movement;
- or integral to the container, such that the upright forms a transverse wall of the container (2).
